# EUROPÄISCHE PATENTSCHRIFT

(11) **EP 3 579 415 B1**
(45) Veröffentlichungstag und Bekanntmachung des Hinweises auf die Patenterteilung: **05.01.2022**
(21) Anmeldenummer: 19178191.3
(22) Anmeldetag: 04.06.2019
(51) Int. Cl.: H03K 17/96

(54) **VERFAHREN ZUR BEDIENUNG EINES ELEKTROKOCHGERÄTS UND ELEKTROKOCHGERÄT**
ELECTRICAL COOKING DEVICE AND METHOD FOR OPERATING AN ELECTRICAL COOKING DEVICE
PROCÉDÉ DE COMMANDE D'UN APPAREIL DE CUISSON ÉLECTRIQUE ET APPAREIL DE CUISSON ÉLECTRIQUE

(30) Priorität: 06.06.2018 DE 102018208939
(43) Veröffentlichungstag der Anmeldung: 11.12.2019
(73) Patentinhaber: E.G.O. Elektro-Gerätebau GmbH, 75038 Oberderdingen (DE)
(72) Erfinder: Eitel, Sandra, 71665 Vaihingen/Enz-Riet (DE); Engelhardt, Patrick, 75038 Oberderdingen (DE); Kleinhans, Andreas, 75031 Eppingen (DE)
(74) Vertreter: Patentanwälte Ruff, Wilhelm, Beier, Dauster & Partner mbB

(56) Entgegenhaltungen:
- WO-A1-2016/202351
- DE-A1-102006 058 873
- DE-A1-102007 057 076
- DE-A1-102015 103 265
- Johannes Schad ET AL: "DESIGN CONCEPTS & TRENDS", Appliance Design Magazin, 1. April 2017 (2017-04-01), XP055625579, Gefunden im Internet: URL:https://www.leonhard-kurz.com/portal/r esource.nsf/imgref/Download_KURZ-Fachartik el_Appliance_Design_Magazine_%204_17.pdf/$ FILE/KURZ-Fachartikel_Appliance_Design_Mag azine_%204_17.pdf [gefunden am 2019-09-24]

## Beschreibung

### Anwendungsgebiet und Stand der Technik

Die Erfindung betrifft ein Verfahren zur Bedienung eines Elektrokochgeräts, insbesondere eines Elektrokochfelds, sowie ein entsprechendes Elektrokochgerät, das eine Bedieneinrichtung aufweist und zur Durchführung dieses Verfahrens ausgebildet ist bzw. mit dem dieses Verfahren durchgeführt werden kann.

Um ein Elektrokochgerät bedienen zu können, sind neben mechanisch drehbaren Drehknebeln oder eindrückbaren Druckknöpfen zunehmend sogenannte Berührungsschalter verbreitet, die insbesondere optisch oder kapazitiv arbeiten. Beispiele für ein Elektrokochfeld mit einer Bedieneinrichtung mit kapazitiven Sensorelementen für Berührungsschalter sind aus der EP 859467 A1 und der DE 102013213036 A1 bekannt. Durch Auflegen eines Fingers auf eine Bedienblende oberhalb eines kapazitiven Sensorelements, in diesem Fall auf einen speziell markierten Bereich der Kochfeldplatte, kann ein mit dem kapazitiven Sensorelement gebildeter Schalter, nämlich der Berührungsschalter, betätigt werden. Insbesondere für einen EIN-Schalter sind dafür spezielle Markierungen als Bedruckung einer Oberfläche der Bedienblende bzw. der Kochfeldplatte üblich.

Aus der DE 10 2015 103 265 A1 sind ein Haushaltsgerät und ein Verfahren zum Bedienen eines Haushaltsgeräts bekannt, wobei ein Näherungssensor im Haushaltsgerät angeordnet ist. Dieser kann ein Annähern eines Objekts, beispielsweise einer Hand, an das Haushaltsgerät erkennen und ein Signal erzeugen, wenn ein erster Schwellenwert überschritten ist. Dann kann eine Mehrzahl von anwählbaren Bediensymbolen in einem Bedienfeld eingeblendet werden, wodurch eine sich annähernde Bedienperson bestimmte Informationen erhalten kann.

Aus der WO 2016/202351 A1 ist es bekannt, einen Näherungssensor an einer Drucktaste für ein elektronisches Haushaltsgerät vorzusehen. Dadurch kann das Annähern eines Objekts, beispielsweise eines Fingers einer Bedienperson, erkannt werden. Vor allem aber soll mit dem Näherungssensor ein Betätigungszustand der Drucktaste bestimmt werden.

Aus der DE 10 2006 058 873 A1 ist es bekannt, für ein Kochfeld einen Berührungsschalter mit kapazitiven Sensorelementen vorzusehen. Zur Kennzeichnung der Berührungsschalter sind auf der Oberseite eine Abdeckung, an der die Berührungsschalter vorgesehen sind, optisch sichtbare Kennzeichnungen aufgedruckt. So können beispielsweise Berührungsschalter zur Änderung einer Leistung und ein EIN-Schalter realisiert werden.

### Aufgabe und Lösung

Der Erfindung liegt die Aufgabe zugrunde, ein eingangs genanntes Verfahren sowie ein zu dessen Durchführung ausgebildetes Elektrokochgerät zu schaffen, mit denen Probleme des Standes der Technik vermieden werden können und es insbesondere möglich ist, ein Elektrokochgerät möglichst vielseitig und möglichst ohne vorgegebene Zwänge auszugestalten sowie eine Bedienung desselben möglichst komfortabel, einfach und intuitiv verständlich auszubilden.

Gelöst wird diese Aufgabe durch ein Verfahren mit den Merkmalen des Anspruchs 1 sowie durch ein Elektrokochgerät mit den Merkmalen des Anspruchs 13, das zur Durchführung des Verfahrens ausgebildet ist. Vorteilhafte sowie bevorzugte Ausgestaltungen der Erfindung sind in den weiteren Ansprüchen enthalten und werden im Folgenden näher erläutert. Dabei werden manche der Merkmale nur für das Verfahren oder nur für das Elektrokochgerät beschrieben. Sie sollen jedoch unabhängig davon sowohl für das Verfahren als auch für das Elektrokochgerät gelten können. Der Wortlaut der Ansprüche wird durch ausdrückliche Bezugnahme zum Inhalt der Beschreibung gemacht.

Es ist vorgesehen, dass das Elektrokochgerät eine Bedieneinrichtung mit einer Bedienblende aufweist, die also eine Oberfläche der Bedieneinrichtung bildet und anhand der oder auf der die Bedienung stattfindet, insbesondere mit Berührungsschaltern. Unter der Bedienblende sind Sensorelemente angeordnet, die vorteilhaft zumindest teilweise kapazitiv arbeiten können, besonders vorteilhaft alle kapazitiv arbeiten. Sie können grundsätzlich aber auch anders arbeiten, müssen aber alle dazu ausgebildet sein, das Annähern oder das Auflegen eines Fingers zu erkennen. Die Sensorelemente bilden Schalter der Bedieneinrichtung, wie dies an sich aus dem Stand der Technik bekannt ist. Manche der Sensorelemente können nur eine einzige Funktion aufweisen, beispielsweise nur als PLUS-Schalter eine Leistung erhöhen oder als MINUS-Schalter eine Leistung verringern, vorteilhaft schrittweise mit einem Schritt bei jeder Betätigung bzw. Bedienung. Andere Sensorelemente, insbesondere für einen EIN-Schalter, können den Schaltzustand der Bedieneinrichtung oder des Elektrokochgeräts wechseln bei jeder Betätigung, also beispielsweise Einschalten oder Ausschalten.

Ein Schalter der Bedieneinrichtung ist mit einem entsprechenden Sensorelement als EIN-Schalter für das Elektrokochgerät ausgebildet. Er kann auch ein EIN-Schalter für die Bedieneinrichtung sein, wobei diese vorteilhaft aber nie ganz ausgeschaltet ist bzw. nie stromlos ist.

Für die Sensorelemente ist wichtig, dass durch Annähern eines Fingers an die Bedienblende oder durch Auflegen eines Fingers auf die Bedienblende oberhalb eines solchen Sensorelements eine Bedienfunktion des zu dem Sensorelement gehörigen Schalters auslösbar ist bzw. diese Bedienfunktion ausgelöst wird. Dazu ist es notwendig, dass durch dieses Annähern oder Auflegen des Fingers an das Sensorelement ein Signal, das eine Signalstärke aufweist, die größer ist als eine erste Signalstärke, am Sensorelement erzeugt und erkannt wird. Dies kann vorteilhaft dadurch erfolgen, dass ein elektrisches Signal eines kapazitiven Sensorelements entsprechend verändert wird. Bei einem optischen Sensorelement eines optischen Berührungsschalters kann dies die Lichtstärke eines reflektierten Signals sein.

Erfindungsgemäß ist vorgesehen, dass in einem ersten Schritt in einem AUS-Zustand des Elektrokochgeräts bzw. möglicherweise auch der Bedieneinrichtung mindestens eines der Sensorelemente in dem Fall, dass ein Signal durch Annähern oder Auflegen eines Fingers auf die Bedienblende oberhalb dieses Sensorelements mit mindestens einer zweiten Signalstärke erzeugt und erkannt worden ist, die Bedieneinrichtung dazu veranlasst, dass ausschließlich das EIN-Sensorelement des EIN-Schalters durch Beleuchtung optisch markiert wird. Dabei ist diese zweite Signalstärke geringer als die erste Signalstärke. Ist dieses Signal also mindestens so hoch, dass es als zweite Signalstärke gewertet wird, möglicherweise aber geringer als die deutlich höhere erste Signalstärke, dann veranlasst die Bedieneinrichtung, dass mindestens das Sensorelement des EIN-Schalters durch Beleuchtung optisch markiert wird, vorzugsweise nur dieses. Eine solche Beleuchtung ist vorteilhaft unterhalb der Bedienblende angeordnet, besonders vorteilhaft direkt am oder sogar durch das Sensorelement. Somit reicht ein Signal mit einer geringeren Signalstärke als der ersten Signalstärke aus, um das optische Markieren des EIN-Sensorelements zu veranlassen. Dabei kann in einer möglichen Ausgestaltung der Erfindung sogar vorgesehen sein, dass für den Fall, dass die Signalstärke größer ist als die erste Signalstärke, keine optische Markierung des EIN-Sensorelements erfolgt, da dann sehr wahrscheinlich ein Finger direkt auf die Bedienblende aufgelegt worden ist. Allgemein kann aber auch bei jeglichem Überschreiten der zweiten Signalstärke das optische Markieren des EIN-Sensorelements erfolgen, wenn das Elektrokochgerät ausgeschaltet ist.

In einem zweiten nachfolgenden Schritt wird ein Finger auf die Bedienblende oberhalb des optisch markierten EIN-Sensorelements des EIN-Schalters aufgelegt, alternativ kann er mit sehr geringem Abstand, vorteilhaft 1 cm oder weniger, darüber gehalten werden. Bevorzugt wird aber ein Signal erzeugt durch Auflegen. Dann wird am EIN-Sensorelement ein Signal mit einer Signalstärke größer als die erste Signalstärke erzeugt und entsprechend erkannt von der Bedieneinrichtung. Daraufhin wird das Elektrokochgerät derart eingeschaltet, dass die Bedieneinrichtung mehrere Sensorelemente von Schaltern durch Beleuchtung optisch markiert, so dass nachfolgend sie bzw. die durch diese Sensorelemente gebildeten Schalter gut, einfach und vorteilhaft bedient werden können. Diese Bedienung erfolgt dann wiederum durch sehr starkes Annähern eines Fingers an die Bedienblende oberhalb eines Schalters, vorteilhaft erst durch Auflegen eines Fingers auf die Bedienblende oberhalb eines Sensorelements. Besonders vorteilhaft werden in diesem zweiten Schritt nach Betätigen des EIN-Schalters alle Sensorelemente von Schaltern der Bedieneinrichtung optisch markiert, insbesondere alle auf im Wesentlichen dieselbe Art und Weise, nämlich durch Beleuchtung. Die Beleuchtung kann möglicherweise funktionsabhängig und/oder zustandsabhängig variiert werden.

Somit ist es mit der Erfindung möglich, dass ein Elektrokochgerät mit elektrisch abgefragten Sensorelementen ausgeschaltet ist, und nur die Bedieneinrichtung eingeschaltet ist. In dem genannten ersten Schritt kann die Bedieneinrichtung in einen Zustand versetzt werden, dass ihre Bedienfunktionen oder -möglichkeiten optisch markiert werden, insbesondere ein EIN-Schalter für das Elektrokochgerät. Durch dessen Betätigen kann dann das gesamte Elektrokochgerät eingeschaltet werden. Somit kann der Zustand bzw. Einschalt-Zustand des Elektrokochgeräts von demjenigen der Bedieneinrichtung abweichen. Da die Sensorelemente für die Schalter elektronisch abgefragt werden, muss die Bedieneinrichtung ohnehin an zumindest einem Sensorelement aktiv sein, vorteilhaft an mehreren oder sogar an allen, so dass sie ohnehin nicht ganz ausgeschaltet werden kann. Im ersten Schritt kann also der EIN-Schalter bzw. sein EIN-Sensorelement optisch markiert werden, und im zweiten Schritt kann er dann leicht identifiziert und ausgemacht werden, und mit ihm das Elektrokochgerät eingeschaltet werden. Hauptsächlicher Zweck der Erfindung ist es nicht, Energie einzusparen beim Betrieb des Elektrokochgeräts bzw. der Bedieneinrichtung. Vielmehr geht es um eine optisch ansprechende Möglichkeit, die Bedieneinrichtung sozusagen erst zu aktivieren für eine nachfolgende Bedienung zum Einschalten des Elektrokochgeräts, wenn zuvor eine entsprechende Benutzerhandlung erfolgt ist. Diese kann das Annähern oder gegebenenfalls sogar Auflegen eines Fingers sein.

Unter ein solches Annähern eines Fingers an die Bedienblende fällt vorteilhaft auch der Fall, dass der Finger oder eine ganze Hand mit einer Art Wischbewegung an und über dem Sensorelement bewegt worden ist, vorteilhaft mit Abstand über der Bedienblende, vorzugsweise mit bis zu 5 cm. Eine Betätigung des Sensorelements kann dann möglicherweise zwar zeitlich nur sehr kurz erfolgen, kann aber auf alle Fälle auch als solche erkannt werden.

Vorteilhaft wird die Erfindung angewendet in dem Fall, dass die Bedienblende im Bereich des Sensorelements des EIN-Schalters ohne optisch erkennbare Markierung ausgebildet ist, also markierungsfrei ausgebildet ist. Besonders vorteilhaft ist im gesamten Bereich der Bedieneinrichtung bzw. oberhalb jedes der Sensorelemente der Bedieneinrichtung keinerlei optische oder sonst wie erkennbare Markierung der Bedienblende vorgesehen. Somit kann diese äußerst schlicht und ungewöhnlich sowie zurückhaltend ausgebildet sein, ohne dass eine Bedienperson im Unklaren bleibt, wie die Bedienung erfolgen kann. Vorzugsweise ist das Elektrokochgerät ein Kochfeld und die Bedienblende wird von einer Kochfeldplatte gebildet, die bevorzugt lichtdurchlässig ist für die optische Markierung von unten. Hierfür eignet sich eine übliche Glaskeramik-Kochfeldplatte. Die Beheizungsart ist nachrangig, sie kann beliebig gemäß dem Stand der Technik sein.

Erfindungsgemäß wird im Falle eines Erzeugens und Erkennens eines Signals mit mindestens der zweiten Signalstärke an einem beliebigen Sensorelement bzw. an irgendeinem der Sensorelemente der Bedieneinrichtung ausschließlich dasjenige Sensorelement optisch markiert, das den EIN-Schalter bildet. Dabei wird es durch Beleuchtung optisch markiert. Abgesehen davon, dass dann durch die spezielle Art der optischen Markierung für die Bedienperson erkennbar sein kann, dass es sich um den EIN-Schalter handelt, beispielsweise durch ein gebräuchliches Symbol, das durch Leuchten angezeigt wird, kann so erreicht werden, dass auf alle Fälle als nächster Schritt das Betätigen des EIN-Schalters und somit das Einschalten des Elektrokochgeräts erfolgt. Beim eingeschalteten Elektrokochgerät können die meisten oder sogar alle Schalter der Bedieneinrichtung betätigt werden.

In weiterer vorteilhafter Ausgestaltung der Erfindung kann vorgesehen sein, dass sämtliche anderen Sensorelemente der Bedieneinrichtung keine Bedienfunktion oder Betätigungsfunktion aufweisen außer derjenigen, das optische Markieren des EIN-Sensorelements des EIN-Schalters zu veranlassen, solange das Elektrokochgerät nicht eingeschaltet ist. So können Fehlbedienungen vermieden werden, da selbst ein direktes Betätigen eines Sensorelements eines beliebigen anderen Schalters durch Auflegen eines Fingers, was ein Signal mit mehr als der ersten Signalstärke erzeugt, nicht die entsprechende Schaltfunktion dieses Schalters bewirkt. Schließlich soll diese noch gar nicht zur Verfügung stehen, da ja das Elektrokochgerät selbst noch nicht eingeschaltet ist und somit auch noch nicht die Funktion dieses Schalters betätigbar sein soll. Es soll ausschließlich der EIN-Schalter bedienbar sein. Dabei kann vorgesehen sein, dass auch der EIN-Schalter bzw. das entsprechende EIN-Sensorelement nicht direkt beim ersten Auflegen eines Fingers betätigt wird, sondern erst dann, wenn es zuvor gemäß einem Verfahren entsprechend dem ersten Schritt optisch markiert worden ist. So kann auch ein versehentliches Einschalten des Elektrokochgeräts vermieden werden.

In weiterer vorteilhafter Ausgestaltung der Erfindung ist vorgesehen, dass der EIN-Schalter hauptsächlich oder ausschließlich zum Einschalten und zum Ausschalten des Elektrokochgeräts ausgebildet ist. Besonders vorteilhaft weist er darüber hinausgehend keine weitere Funktion auf.

In weiterer Ausgestaltung der Erfindung kann vorgesehen sein, dass mehrere Sensorelemente, vorzugweise alle Sensorelemente, im vorgenannten ersten Schritt derart angesteuert werden, dass sie das Annähern oder Auflegen eines Fingers auf die Bedienblende mit einer Signalstärke, die mindestens die zweite Signalstärke beträgt, erkennen. Somit ist es egal, an welchem der Sensorelemente im ersten Schritt durch Annähern mit einem Finger oder durch eine vorgenannte Wischbewegung mit einem Finger oder mit einer ganzen Hand eine optische Markierung des Sensorelements des EIN-Schalters bewirkt wird. Dadurch ist ein Aktivieren der optischen Markierung des EIN-Sensorelements leicht möglich, weil dies sozusagen an allen Sensorelementen der Bedieneinrichtung erfolgen kann. Dabei ist allgemein vorteilhaft vorgesehen, dass die Sensorelemente bei Betätigen mit mindestens der zweiten Signalstärke im ersten Schritt ihre eigentlich zugeteilte Bedienfunktion des Schalters nicht bewirken bzw. ausüben, besonders vorteilhaft noch nicht einmal bei Überschreiten der ersten Signalstärke.

In vorteilhafter Ausgestaltung der Erfindung ist vorgesehen, dass die optische Markierung des EIN-Sensorelements im zweiten Schritt und somit auch die Möglichkeit, dieses zum Einschalten des Elektrokochgeräts zu nutzen, zeitlich begrenzt erfolgt. Eine Begrenzung kann auf eine Zeit von 3 sek bis 10 sek erfolgen. Das kann auch sinnvoll sein, weil die niedrigere zweite Signalstärke nicht gegen EMV-Einfluss sicher sein muss. Nach Ablauf dieser Zeit wird die optische Markierung wieder rückgängig gemacht bzw. das Sensorelement des EIN-Schalters wird nicht mehr optisch markiert. So wird einer Bedienperson auch angezeigt, dass das Elektrokochgerät nun nicht mehr direkt eingeschaltet werden kann, selbst wenn eine Bedienperson den Finger an die richtige Stelle oberhalb des Sensorelements des EIN-Schalters auflegt.

Bevorzugt ist die erste Signalstärke deutlich größer als die zweite Signalstärke. Sie kann um das Fünffache bis Fünfzigfache größer sein, vorzugsweise um das Zehnfache bis Zwanzigfache. Hier sollte vorgesehen sein, dass die erste Signalstärke für das sozusagen normale Betätigen eines Schalters in der üblichen Größenordnung liegt. Für eine Auswertung der Sensorelemente mittels eines Controllers, insbesondere mit einer 12 bit-Auflösung, in der Bedieneinrichtung kann die erste Signalstärke 10 Digits bis 200 Digits betragen, vorzugsweise 60 Digits bis 100 Digits. Die zweite Signalstärke ist demzufolge deutlich niedriger, insbesondere zehnmal bis zwanzigmal niedriger. Dennoch kann auch hier eine Unterscheidung der Signalstärken noch vorgenommen werden. Vor allem ist durch eine derart niedrige zweite Signalstärke gewährleistet, dass eben auch durch ein schnelles Bewegen eines Fingers oder der Hand mit einer Art Wischbewegung oberhalb der Bedieneinrichtung bzw. oberhalb eines der Sensorelemente, beispielsweise mit mehreren cm Abstand zur Oberseite der Bedienblende, ein zuverlässiges Erkennen desselben Vorgangs erfolgt, um das Sensorelement des EIN-Schalters optisch markieren zu können. Entsprechend kann die zweite Signalstärke 3 Digits bis 10 Digits betragen, vorzugsweise 5 Digits bis 7 Digits, und zwar an dem vorgenannten Controller der Bedieneinrichtung. Für verschiedene Controller bzw. eine andere Auflösung können hier auch andere Werte vorteilhaft oder gültig sein.

In vorteilhafter Ausgestaltung der Erfindung werden die Sensorelemente mehr als einmal pro Sekunde von der Bedieneinrichtung abgefragt, besonders vorteilhaft alle Sensorelemente. Damit kann geprüft werden, ob sich ein Finger angenähert hat an die Bedienblende oder aufgelegt worden ist auf die Bedienblende oberhalb eines Sensorelements zu diesem Zeitpunkt. Vor allem ein Annähern muss nicht zwingend genau oberhalb des Sensorelements oder mit Richtung senkrecht zu der Bedienblende oberhalb davon erfolgen, insbesondere wenn es sich um ein kapazitives arbeitendes Sensorelement handelt.

Es hat sich als vorteilhaft erwiesen, wenn ein Sensorelement mindestens zehnmal pro Sekunde abgefragt wird. Bei einem optisch arbeitenden Sensorelement nach Art einer Reflex-Lichtschranke würde entsprechend zehnmal pro Sekunde ein Lichtsignal ausgesendet werden. Zum Auslösen des optischen Markierens des Sensorelements des EIN-Schalters reicht es aus, wenn während einer einzigen dieser Abfragen ein Signal erkannt wird, dessen Signalstärke größer ist als die zweite Signalstärke. Damit wird zwar bewusst in Kauf genommen, dass es eventuell auch zu einer Fehlauslösung kommen kann, beispielsweise weil sich nicht ein Finger einem der Sensorelemente genähert hat, sondern ein Ellenbogen oder eine Hand oder ein in der Hand gehaltener metallischer Gegenstand, vor allem auch unbeabsichtigt. Dann kann die Bedienperson, falls es ihr überhaupt auffällt, das optische Markieren des EIN-Sensorelements aber getrost vernachlässigen, da sie weiß, dass das Elektrokochgerät ja nicht eingeschaltet werden soll und sie auch nichts unternehmen muss, da es die optische Markierung ja wieder selbst zurücknimmt, und demzufolge nichts passieren kann.

Es kann vorgesehen sein, die Bedieneinrichtung derart auszubilden, dass bei einem Abstand eines Fingers, vorzugsweise eines Fingers eines Erwachsenen, von maximal 5 cm oder sogar nur von maximal 3 cm, oberhalb der Bedienblende oberhalb eines Sensorelements, vorzugsweise eines kapazitiven Sensorelements, ein Signal mit mindestens der zweiten Signalstärke erzeugt und erkannt wird. Dadurch ist es möglich, dass eine eingangs genannte Wischbewegung eben wirklich mit etwas Abstand oberhalb der Bedienblende erfolgen kann. So ist der Vorgang des optischen Markierens des EIN-Schalters für die Bedienperson auch leicht zu unterscheiden von einem tatsächlichen Bedienvorgang, beispielsweise zum Betätigen des EIN-Schalters.

In weiterer Ausgestaltung der Erfindung kann vorgesehen sein, dass akustische Signale ausgegeben werden an die Bedienperson, abhängig davon, was an der Bedieneinrichtung passiert. Dabei kann vorgesehen sein, dass das Auslösen eines Signals mit mehr als der zweiten Signalstärke noch nicht akustisch quittiert oder bestätigt wird. Dies kann vorteilhaft erst dann erfolgen, wenn ein Sensorelement, insbesondere dasjenige des EIN-Schalters, mit einer Signalstärke oberhalb der ersten Signalstärke betätigt worden ist. So kann vermieden werden, dass eine Bedienperson bei einem unbeabsichtigten Auslösen des optischen Markierens des EIN-Sensorelements des EIN-Schalters zusätzlich auch noch mit einem akustischen Signal verwirrt oder ggf. belästigt wird.

Eine optische Markierung eines oder aller Sensorelemente erfolgt vorteilhaft durch Beleuchtung. Besonders vorteilhaft ist dies eine Beleuchtung von unten bzw. unterhalb der Bedienblende. Dabei kann eine Beleuchtung vorteilhaft durch die Fläche eines kapazitiven Sensorelements hindurchgehen, wie es beispielsweise aus der eingangs genannten EP 859467 A1 oder DE 102013213036 A1 bekannt ist. Eine Beleuchtung kann vorteilhaft durch eine LED erfolgen. Alternativ könnte eine optische Markierung des EIN-Sensorelements des EIN-Schalters auch noch durch Projektion von oben erfolgen, beispielsweise ausgehend von einer Dunstabzugshaube. Hierzu wird auf den an sich bekannten Stand der Technik verwiesen zu dieser Möglichkeit der Projektion auf ein Kochfeld.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelnen Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Draufsicht von oben auf ein erfindungsgemäßes Kochfeld mit gestrichelt dargestellten Funktionseinheiten,
- Fig. 2: eine Draufsicht auf das Kochfeld von Fig. 1 im Zustand nach dem erfindungsgemäßen ersten Schritt, wenn ein kapazitives EIN-Sensorelement eines EIN-Schalters optisch durch Beleuchtung markiert ist,
- Fig. 3: das Kochfeld aus Fig. 2 nach dem erfindungsgemäßen zweiten Schritt, wenn es durch Auflegen eines Fingers über dem EIN-Sensorelement eingeschaltet ist und die weiteren Sensorelemente der anderen Schalter beleuchtet werden sowie zumindest manche Anzeigen aktiviert werden,
- Fig. 4: eine Schnittdarstellung durch das Kochfeld entsprechend Fig. 1, wenn ein Finger in einer Wischbewegung oder sonstigen Bewegung auf einer bestimmten Höhe über einer Kochfeldplatte über das EIN-Sensorelement gebracht ist,
- Fig. 5: eine Schnittdarstellung durch das Kochfeld entsprechend Fig. 2, wenn das EIN-Sensorelement durch ausreichendes Annähern des Fingers daran optisch markiert worden ist,
- Fig. 6: die Darstellung aus Fig. 5 kurze Zeit später, wenn zum Einschalten des Kochfelds ein Finger auf die Kochfeldplatte oberhalb des EIN-Sensorelements aufgelegt worden ist, bevor dann das Kochfeld in den Zustand gemäß Fig. 3 wechselt, und
- Fig. 7: einen Verlauf der Signalstärke über dem Abstand des Fingers entsprechend Fig. 4 über der Oberseite der Kochfeldplatte samt erster und zweiter Signalstärke.

### Detaillierte Beschreibung der Ausführungsbeispiele

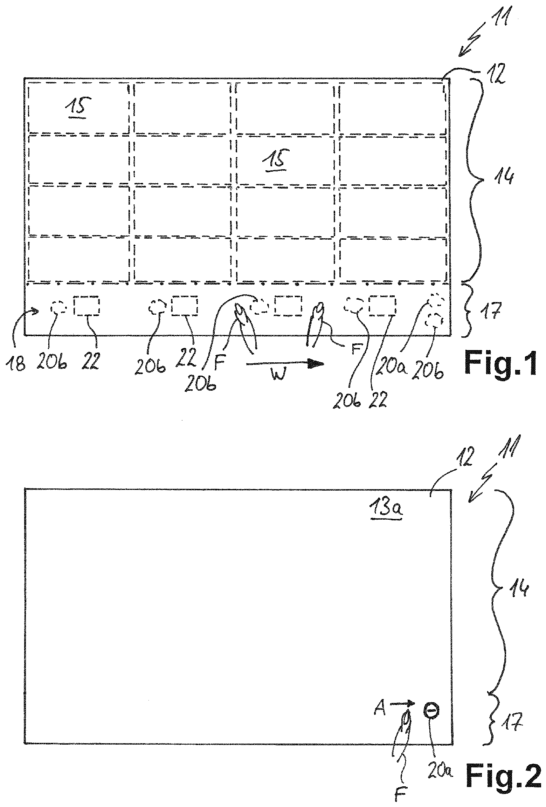

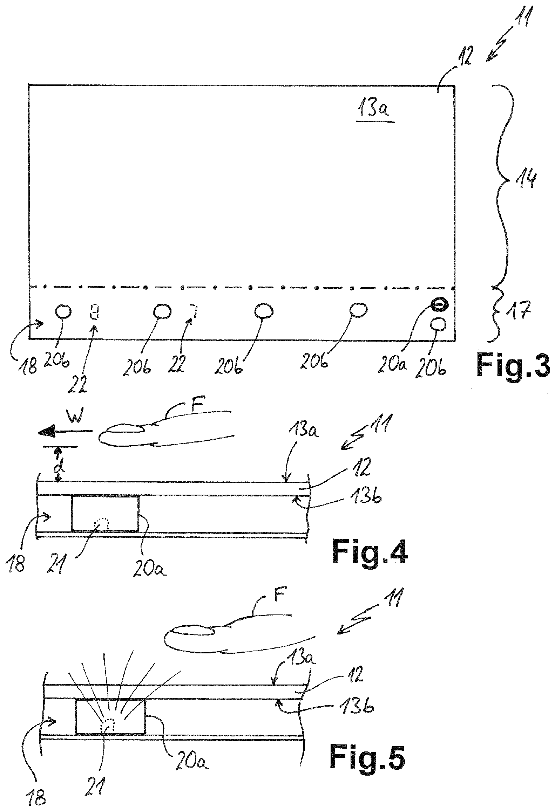

In der Fig. 1 ist ein erfindungsgemäßes Kochfeld 11 in Draufsicht und in Fig. 4 im Teilschnitt dargestellt, das eine Kochfeldplatte 12 aufweist, die aus üblicherweise verwendeter Glaskeramik mit rötlich-brauner Durchfärbung besteht. Die Kochfeldplatte 12 ist also im normalen Zustand ohne Hinterleuchtung oder starke Beleuchtung von oben undurchsichtig bzw. nicht durchsichtig. Die Kochfeldplatte 12 weist eine Oberseite 13a und eine Unterseite 13b auf. Des Weiteren ist sie durch eine strichpunktierte Linie in einen hinteren Heizbereich 14 und einen vorderen Bedienbereich 17 unterteilt. Im Heizbereich 14 befinden sich strichliert dargestellte Induktionsheizspulen 15, hier sechzehn Induktionsheizspulen 15 in vier Reihen und vier Spalten. Damit kann ein an sich beliebig großes Kochgefäß an beliebiger Stelle passend beheizt werden. Es könnte natürlich auch anders beheizt werden, beispielsweise mit Strahlungsheizeinrichtungen oder mit Gasbrennern.

Im vorderen Bedienbereich 17 ist eine Bedieneinrichtung 18 angeordnet mit kapazitiven Sensorelementen 20, die auf bekannte Art und Weise Schalter bilden. Es könnten beispielsweise auch andere Sensorelemente vorgesehen sein, die optisch arbeiten nach Art einer Reflex-Lichtschranke entsprechend der DE 10211047 A1 oder der EP 1602882 A1. Dargestellt ist hier ein vorteilhaft vorgesehenes kapazitives EIN-Sensorelement 20a, das einen EIN-Schalter bildet, wie eingangs erläutert worden ist. Des Weiteren sind noch mehrere weitere kapazitive Sensorelemente 20b vorgesehen. Neben vier dieser kapazitiven Sensorelemente 20b ist rechts jeweils eine Anzeige 22 vorgesehen unter der Kochfeldplatte 12, vorteilhaft als doppelte Sieben-Segment-Anzeige.

Die Funktionseinheiten sowohl im Heizbereich 14 als auch im Bedienbereich 17 sind gestrichelt dargestellt, was hier veranschaulichen soll, dass sie von oben nicht erkennbar sind. Die gesamte Kochfeldplatte 12 ist an ihrer Oberseite 13a markierungsfrei bzw. ohne Kennzeichnung odgl. ausgebildet. Es sind also weder eine Bedruckung noch Oberflächenbearbeitungen im Sinne von angeschliffenen Bereichen, mattierten Bereichen oder glänzenden Bereichen vorgesehen. Im Fall der vorgenannten Glaskeramikplatte liegt also eine übliche glänzende dunkle Oberfläche ohne Unterbrechung oder Markierung vor.

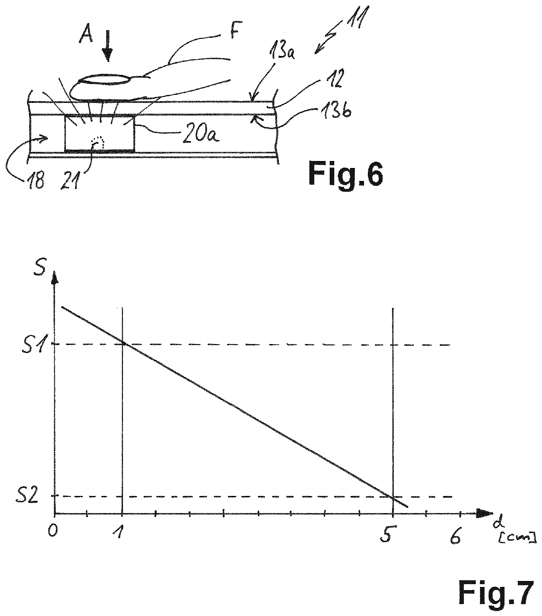

Die Bedieneinrichtung 18 weist, vorteilhaft integriert in einen Controller, die zuvor erläuterte Funktionalität auf, dass sie die kapazitiven Sensorelemente 20, also sowohl das kapazitive EIN-Sensorelement 20a des EIN-Schalters als auch die übrigen kapazitiven Sensorelemente 20b, so ansteuert, dass nicht nur ein Signal mit einer ersten Signalstärke S1 entsprechend Fig. 7 als Bedienung ausgewertet wird oder irgendeine Aktion veranlasst, sondern bereits ein Signal mit der deutlich niedrigeren Signalstärke S2. Aus der Fig. 7 ist zu ersehen, dass die niedrigere Signalstärke S2 bereits erreicht werden kann, wenn sich ein durchschnittlicher Finger eines Erwachsenen entsprechend der Fig. 4 in einer Höhe bzw. mit einem Abstand d = 5 cm über der Oberseite 13a der Kochfeldplatte 12 befindet. Würde dieser Abstand d noch geringer bzw. unter die 5 cm entsprechend Fig. 7 fallen, so würde die Signalstärke noch deutlicher über der zweiten Signalstärke S2 liegen.

In der Fig. 1 ist dargestellt, wie ein Finger F eines durchschnittlichen Erwachsenen von links nach rechts in einer Wischbewegung W über den Bedienbereich 17 geführt ist. Dabei kann diese Wischbewegung W in unterschiedlicher Höhe über der Kochfeldplatte 12 bzw. über dem Bedienbereich 17 erfolgen, insbesondere kann sie mit Abstand erfolgen, also ohne die Kochfeldplatte zu berühren. Im Verlauf dieser Wischbewegung W sollte jedoch ein Abstand d des Fingers F zu der Oberseite 13a der Kochfeldplatte 12 über einem der kapazitiven Sensorelemente 20, hier das vierte kapazitive Sensorelement 20b von links, führen, wobei d ≤ 5 cm sein sollte. Dann wird an diesem vierten kapazitiven Sensorelement 20b ein Signal mit der zweiten Signalstärke S2 erzeugt bzw. von der Bedieneinrichtung 18 auch erkannt. Dieses Signal kann, wie eingangs erläutert worden ist, auch nur für eine sehr kurze Zeit anliegen oder erkennbar sein. Es kann an dem vorgenannten Controller auch im Bereich von fünf Digits bis sieben Digits liegen und muss nur bei einer einzigen Abfrage, von denen mehrere pro Sekunde durchgeführt werden können, erkannt werden. Dann schaltet die Bedieneinrichtung erfindungsgemäß sozusagen den EIN-Schalter aktiv in der Form, dass das kapazitive Sensorelement 20a dieses EIN-Schalters optisch markiert wird durch Beleuchtung. Dies erfolgt auf übliche Art und Weise, dargestellt in Fig. 5 mit der LED 21, die leuchtet und dabei von unten durch die Kochfeldplatte 12 nach oben strahlt bzw. von oben sichtbar ist. Dadurch kann auch ein bestimmtes Symbol entsprechend einem EIN-Schalter angezeigt werden, beispielsweise durch eine Beleuchtung genau in dieser Symbolform oder durch eine Beleuchtung, bei der dieses Symbol maskiert ist. Das Symbol ist vorteilhaft ein runder Kreis mit einem mittigen horizontalen Strich. In der Fig. 2 rechts unten ist dieses kapazitive EIN-Sensorelement 20a in der optisch markierten Form anhand seines Symbols zu erkennen.

In diesem Zustand entsprechend Fig. 2 mit der eingeschalteten Bedieneinrichtung 18 ist am gesamten Kochfeld 11 bzw. auf der Oberseite 13a der Kochfeldplatte 12 nichts zu sehen bzw. zu erkennen außer diesem optisch markierten kapazitiven EIN-Sensorelement 20a.

Zu dem Einschaltzustand der Bedieneinrichtung 18 ist zu sagen, dass sie sozusagen nie ganz ausgeschaltet ist bzw. nie ohne Stromzufuhr ist. Ansonsten könnten die Schalter mit den kapazitiven Sensorelementen 20 ja überhaupt nicht funktionieren. Es ist aber vorgesehen, dass ein Zustand der Bedieneinrichtung 18 hier so zu verstehen ist, dass sie im EIN-Zustand des Kochfelds 11 voll eingeschaltet ist, also sämtliche kapazitiven Sensorelemente 20 der Schalter optisch markiert sind in einer Art und Weise, wie es eben ein Zustand einer üblichen Bedieneinrichtung ist, wenn das Kochfeld 11 eingeschaltet ist. Insofern werden hier eben auch erfindungsgemäß der EIN-Zustand und der AUS-Zustand des Elektrokochgeräts selbst definiert. Im Zustand der Fig. 1 und der Fig. 2 ist das Kochfeld 11 noch ausgeschaltet. Erst wenn gemäß Fig. 2 und 6 der Finger F das kapazitive EIN-Sensorelement 20a betätigt und dabei auf die Oberseite 13a der Kochfeldplatte 12 oberhalb des EIN-Sensorelements 20a gelegt wird, welches optisch markiert ist, wird das Elektrokochfeld 11 eingeschaltet, siehe Fig. 3. Gemäß dieser Fig. 3 sind dann nämlich auch die in Fig. 1 nur gestrichelt dargestellten kapazitiven Sensorelemente 20b optisch markiert, vorteilhaft jeweils durch Beleuchtung. Damit können einzelne Induktionsheizspulen 15 eingeschaltet bzw. aktiviert werden zum Beheizen eines auf den Heizbereich 14 aufgestellten Kochgefäßes. Dieses Beheizen kann hinsichtlich einer Leistungsstufe an einer der Anzeigen 22, von denen hier links zwei als Sieben-Segment-Anzeigen dargestellt sind, angezeigt werden.

Entsprechend der vorgenannten Definition ist hier bei dem Ausführungsbeispiel im AUS-Zustand des Elektrokochgeräts nichts von Bedienelementen zu erkennen, da weder eine permanente optische Markierung an der Oberseite vorgesehen ist noch eine Beleuchtung odgl., die dynamisch vorgesehen sein könnte, erfolgt. Eine permanente Beleuchtung würde den Energieverbrauch auch subjektiv zu stark erhöhen. Des Weiteren kann es speziell ermöglicht werden, dass bei ausgeschaltetem Kochfeld nichts zu sehen ist. Nach dem Darüberwischen mit der Wischbewegung W eines Fingers F entsprechend Fig. 1 über mindestens eines der kapazitiven Sensorelemente 20 mit mindestens einer zweiten Signalstärke S2 ist das Kochfeld 11 immer noch ausgeschaltet. Die Bedieneinrichtung 18 ist jedoch derart aktiviert, dass sie das EIN-Sensorelement 20a optisch markiert und somit bedienbar macht. Nach dessen Bedienung entsprechend der Fig. 2 und 6 ist das Kochfeld 11 eingeschaltet bzw. im EIN-Zustand, wie dies auch die Fig. 3 zeigt.

Der Signalstärkenverlauf S über dem Abstand d des Fingers F zur Oberseite 13a der Kochfeldplatte 12 direkt über einem kapazitiven Sensorelement 20 ist gem. Fig. 7 dargestellt. Eigentlich besteht die Abhängigkeit zum Abstand des Fingers F vom Sensorelement 20 an sich, also auch in schräger Richtung. Für die hier geltenden Betrachtungen reicht aber die vereinfachte Annahme des Abstands d des Fingers F zur Oberseite 13a der Kochfeldplatte 12 direkt über einem der Sensorelemente 20.

Aus Fig. 7 ist zu erkennen, dass der Signalstärkenverlauf für S eine Gerade ist, es also ein linearer Zusammenhang ist. Dies muss nicht zwingend so sein, das gilt für dieses Ausführungsbeispiel. Der Verlauf könnte auch anders sein, beispielsweise konvex nach oben gewölbt sein.

Es ist auch zu erkennen, dass die zweite Signalstärke S2 viel geringer ist als die erste Signalstärke S1 und beispielsweise zehnfach bis zwanzigfach kleiner ist. Dies liegt daran, dass durch unbeabsichtigtes Darüberwischen mit einem Finger oder sonstiges Auslösen eines der kapazitiven Sensorelemente bzw. des zugehörigen Schalters das Kochfeld 11 hier noch nicht eingeschaltet wird bzw. werden soll, sondern lediglich das EIN-Sensorelement 20a beleuchtet wird. Dies soll dann ja eben die gewohnte und zielgerichtete Möglichkeit zum EIN-Schalten ermöglichen. Vorteilhaft wird die Beleuchtung des EIN-Sensorelements 20a nach einer Zeit zwischen 3 sek oder 5 sek und 10 sek wieder rückgängig gemacht. So lange hat eine Bedienperson also Zeit, das Kochfeld 11 dann tatsächlich einzuschalten. Erfolgte die Aktivierung ungewollt bzw. unbeabsichtigt, so unterlässt die Bedienperson das Betätigen des EIN-Sensorelements 20a bzw. des EIN-Schalters, und dessen optische Markierung verschwindet dann wieder nach der vorgenannten Zeit.

Eine Bedienperson muss auch überhaupt nicht wissen, wo genau oder auch nur wo ungefähr das EIN-Sensorelement des EIN-Schalters angeordnet ist. Es reicht, wenn sie mit der Hand knapp oberhalb der Oberseite 13a der Kochfeldplatte 12 vorbeiwischt oder ggf. sogar die Hand oder einen Finger darauf auflegt, und zwar nahe einem beliebigen Sensorelement 20. Schließlich kennt eine Bedienperson entweder bereits dieses spezielle Kochfeld 11 oder weiß zumindest, dass eine Bedieneinrichtung im vorderen Bereich ist, weil dies ganz üblich ist. Ein solches grobes Annähern an ein beliebiges der Sensorelemente 20 reicht also bereits aus, damit speziell das kapazitive EIN-Sensorelement 20a durch Beleuchtung optisch markiert wird, um es betätigen zu können zum Einschalten des Kochfelds. Es muss also nur ein beliebiges der Sensorelemente 20 ausgelöst werden mit der niedrigeren zweiten Signalstärke S2. Bei eingeschaltetem Kochfeld werden dann alle Sensorelemente für Funktionen, die nun auslösbar bzw. bedienbar sind, optisch durch Beleuchtung markiert.

Damit kann ein Elektrokochfeld mit einer Oberseite 13a seiner Kochfeldplatte 12 geschaffen werden, welches optisch sehr schlicht und zurückhaltend gestaltet sein kann, da eben an der Oberseite nichts zu erkennen ist. Des Weiteren kann Aufwand für eine Bedruckung der Oberseite 13a eingespart werden. Schließlich kann auch eine Variantenvielfalt sehr leicht erreicht werden, da eben nicht pro Variante mit möglicherweise unterschiedlich angeordneten kapazitiven Sensorelementen 20 eine jeweils genau abgestimmt bedruckte Kochfeldplatte hergestellt werden muss.

## Patentansprüche

1. Verfahren zur Bedienung eines Elektrokochgeräts (11), insbesondere eines Elektrokochfelds, wobei:
- das Elektrokochgerät (11) eine Bedieneinrichtung (18) mit einer Bedienblende (12) und mit unter der Bedienblende angeordneten Sensorelementen (20) aufweist,
- die Sensorelemente (20) Schalter der Bedieneinrichtung (18) bilden,
- ein Schalter mit einem EIN-Sensorelement (20a) als EIN-Schalter für das Elektrokochgerät (11) ausgebildet ist,
- durch Annähern oder Auflegen eines Fingers (F) auf die Bedienblende (12) oberhalb eines Sensorelements (20) eine Bedienfunktion des zugehörigen Schalters auslösbar ist und diese Bedienfunktion ausgelöst wird, wenn durch dieses Annähern oder Auflegen des Fingers (F) an das Sensorelement (20) ein Signal, das eine Signalstärke (S) größer als eine erste Signalstärke (S1) aufweist, am Sensorelement erzeugt und von der Bedieneinrichtung (18) erkannt wird, wobei eine Signalstärke größer wird, wenn der Abstand des Fingers zu der Bedienblende geringer wird, wobei
- in einem ersten Schritt in einem AUS-Zustand des Elektrokochgeräts (11) mindestens eines der Sensorelemente (20) im Falle eines Erzeugens am Sensorelement (20) und Erkennens von der Bedieneinrichtung (18) eines Signals durch Annähern oder Auflegen eines Fingers (F) auf die Bedienblende (12) oberhalb dieses Sensorelements (20) mit mindestens einer zweiten Signalstärke (S2) dieses Signals, die geringer ist als die erste Signalstärke (S1), die Bedieneinrichtung (18) dazu veranlasst, dass mindestens das EIN-Sensorelement (20a) des EIN-Schalters durch Beleuchtung optisch markiert wird,
- in einem zweiten nachfolgenden Schritt durch Auflegen des Fingers (F) auf die Bedienblende (12) oberhalb dieses optisch markierten EIN-Sensorelements (20a) des EIN-Schalters mit Erzeugen und Erkennen eines Signals mit einer Signalstärke (S), die größer ist als die erste Signalstärke (S1), das Elektrokochgerät (11) eingeschaltet wird derart, dass die Bedieneinrichtung (18) mehrere, insbesondere alle, Sensorelemente (20) von Schaltern durch Beleuchtung optisch markiert für eine mögliche nachfolgende Bedienung der durch die Sensorelemente (20) gebildeten Schalter durch Annähern oder Auflegen eines Fingers (F) oberhalb davon auf die Bedienblende (12),
**dadurch gekennzeichnet, dass** im Falle eines Erzeugens und Erkennens eines Signals mit der zweiten Signalstärke (S2) an einem beliebigen Sensorelement (20) ausschließlich das EIN-Sensorelement (20a) des EIN-Schalters durch Beleuchtung optisch markiert wird.

2. Verfahren nach Anspruch 1, **dadurch gekennzeichnet, dass** die Bedienblende (12) im Bereich des EIN-Sensorelements (20a) ohne optisch erkennbare Markierung bzw. markierungsfrei ausgebildet ist, wobei vorzugsweise im Bereich der Bedieneinrichtung (18) oder oberhalb jedes der Sensorelemente (20) keinerlei optische Markierung auf der Bedienblende (12) vorhanden ist, insbesondere keine Bedruckung odgl. an der Oberseite (13a) der gesamten Bedienblende oder eines Teils, das die Bedienblende bildet.

3. Verfahren nach Anspruch 1 oder 2, **dadurch gekennzeichnet, dass** der EIN-Schalter nur zum Einschalten und zum Ausschalten des Elektrokochgeräts (11) ausgebildet ist, vorzugsweise ohne jegliche weitere Funktion.

4. Verfahren nach einem der vorhergehenden Ansprüche, **dadurch gekennzeichnet, dass** mehrere, vorzugsweise alle, Sensorelemente (20) im ersten Schritt derart angesteuert werden, dass sie das Annähern oder Auflegen eines Fingers (F) auf die Bedienblende (12) mit einer Signalstärke (S) mit mindestens der zweiten Signalstärke (S2) erkennen.

5. Verfahren nach einem der vorhergehenden Ansprüche, **dadurch gekennzeichnet, dass** die optische Markierung des EIN-Sensorelements (20a) zum Einschalten der Bedieneinrichtung (18) im zweiten Schritt zeitlich begrenzt erfolgt, insbesondere begrenzt auf eine Zeit von 3 sek bis 10 sek, wobei die optische Markierung danach wieder rückgängig gemacht wird.

6. Verfahren nach einem der vorhergehenden Ansprüche, **dadurch gekennzeichnet, dass** die erste Signalstärke (S1) um das Fünffache bis Fünfzigfache größer ist als die zweite Signalstärke (S2), vorzugsweise um das Zehnfache bis Zwanzigfache.

7. Verfahren nach einem der vorhergehenden Ansprüche, **dadurch gekennzeichnet, dass** die erste Signalstärke (S1) 10 Digits bis 200 Digits, vorzugsweise 60 Digits bis 100 Digits, an einem Controller der Bedieneinrichtung (18) beträgt.

8. Verfahren nach einem der vorhergehenden Ansprüche, **dadurch gekennzeichnet, dass** die zweite Signalstärke (S2) 3 Digits bis 10 Digits, vorzugsweise 5 Digits bis 7 Digits, an einem Controller der Bedieneinrichtung (18) beträgt.

9. Verfahren nach einem der vorhergehenden Ansprüche, **dadurch gekennzeichnet, dass** die Sensorelemente (20) mehr als einmal pro Sekunde von der Bedieneinrichtung (18) abgefragt werden, ob ein Finger (F) sich angenähert hat an oder aufgelegt worden ist auf die Bedienblende (12) oberhalb eines Sensorelements (20), vorzugsweise mindestens 10 mal pro Sekunde abgefragt werden, wobei es ausreicht zum optischen Markieren des EIN-Sensorelements (20a), wenn während einer einzigen dieser Abfragen ein Signal mit einer Signalstärke (S) größer als die zweite Signalstärke (S2) erkannt wird.

10. Verfahren nach einem der vorhergehenden Ansprüche, **dadurch gekennzeichnet, dass** die Bedieneinrichtung (18) derart ausgebildet ist, dass bei einem Abstand eines Fingers (F), von maximal 5 cm, insbesondere von maximal 3 cm, oberhalb der Bedienblende (12) oberhalb eines Sensorelements (20) ein Signal mit der zweiten Signalstärke (S2) am Sensorelement (20) erzeugt und von der Bedieneinrichtung (18) erkannt wird

11. Verfahren nach einem der vorhergehenden Ansprüche, **dadurch gekennzeichnet, dass** eine akustische Signalisierung nicht erfolgt bevor nicht ein Sensorelement (20) mit einer Signalstärke (S) oberhalb der ersten Signalstärke (S1) betätigt worden ist.

12. Verfahren nach einem der vorhergehenden Ansprüche, **dadurch gekennzeichnet, dass** eine optische Markierung eines Sensorelements (20) durch Beleuchtung von unten gemacht wird, vorzugsweise mittels LED (21), insbesondere durch die Sensorelemente (20) hindurch.

13. Elektrokochgerät, insbesondere Elektrokochfeld (11), das eine Bedieneinrichtung (18) mit einer Bedienblende (12) und mit unter der Bedienblende (12) angeordneten Sensorelementen (20) aufweist, wobei:
- die Sensorelemente (20) Schalter der Bedieneinrichtung (18) bilden,
- die Bedieneinrichtung (18) derart ausgebildet ist, dass durch Annähern oder Auflegen eines Fingers (F) auf die Bedienblende (12) oberhalb eines Sensorelements (20) eine Bedienfunktion des zugehörigen Schalters auslösbar ist und diese Bedienfunktion ausgelöst wird, wenn durch dieses Annähern oder Auflegen des Fingers (F) an das Sensorelement (20) ein Signal, das eine Signalstärke (S) größer als eine erste Signalstärke (S1) aufweist, am Sensorelement (20) erzeugt und von der Bedieneinrichtung erkannt wird, wobei eine Signalstärke größer wird, wenn der Abstand des Fingers zu der Bedienblende geringer wird, wobei
- ein Schalter mit einem EIN-Sensorelement (20a) als EIN-Schalter für das Elektrokochgerät (11) ausgebildet ist,
- die Bedieneinrichtung (18) eine Steuerung aufweist, die dazu ausgebildet ist, dass das Verfahren nach einem der vorhergehenden Ansprüche mit ihr durchgeführt wird.

## Claims

1. Method for operating an electrical cooking device (11), in particular an electrical cooktop, wherein:
- the electrical cooking device (11) has an operator control device (18) with an operator control panel (12) and with sensor elements (20) disposed below the control panel,
- the sensor elements (20) are switches of the operator control device (18),
- a switch with an ON sensor element (20a) is an ON switch for the electrical cooking device (11),
- by approaching or placing a finger (F) onto the operator control panel (12) above a sensor element (20) an operating function of the related switch is triggerable and said operating function is triggered if, by said approaching or placing-on of the finger (F) to the sensor element (20), a signal which has a signal strength (S) greater than a first signal strength (S1) is generated on the sensor element and detected by the operator control device (18), wherein a signal strength is increasing with a decreasing distance of the finger to the operator control panel, wherein
- in a first step in an OFF state of the electrical cooking device (11) at least one of the sensor elements (20) in case of generation on the sensor element (20) and detection by the operator control device (18) of a signal by approaching or placing-on of a finger (F) onto the operator control panel (12) above said sensor element (20) with at least a second signal strength (S2) of said signal, which strength is less than the first signal strength (S1), the operator control device (18) is caused to optically mark at least the ON sensor element (20a) of the ON switch by illumination,
- in a second subsequent step by placing the finger (F) onto the operator control panel (12) above said optically marked ON sensor element (20a) of the ON switch with generating and detecting a signal having a signal strength (S) greater than the first signal strength (S1), the electrical cooking device (11) is switched on such that the operator control device (18) optically marks a plurality of, in particular all, sensor elements (20) of switches by illumination for a possible subsequent operation of the switches formed by the sensor elements (20) by approaching or placing a finger (F) above onto the operator control panel (12),
**characterized in that**
in case of generation and detection of a signal having the second signal strength (S2) on any sensor element (20) exclusively the ON sensor element (20a) of the ON switch is optically marked by illumination.

2. Method according to claim 1, **characterized in that** the operator control panel (12) in the vicinity of the ON sensor element (20a) is without optically detectable marking or free of marking, wherein preferably in the vicinity of the operator control device (18) or above each of the sensor elements (20) no optical marking whatsoever is located on the operator control panel (12), in particular no printing or the like on the upper side (13a) of the entire operator control panel or a part that is the operator control panel.

3. Method according to claim 1 or 2, **characterized in that** the ON switch is configured only for switching on and for switching off the electrical cooking device (11), preferably without any further function.

4. Method according to any of the preceding claims, **characterized in that** a plurality of, preferably all, sensor elements (20) are controlled in the first step such that they detect the approaching or placing of a finger (F) onto the operator control panel (12) with a signal strength (S) with at least the second signal strength (S2).

5. Method according to any of the preceding claims, **characterized in that** the optical marking of the ON sensor element (20a) for switching on the operator control device (18) in the second step is given for a limited period in time, in particular limited to a period of 3 seconds to 10 seconds, wherein thereafter the optical marking is turned back again.

6. Method according to any of the preceding claims, **characterized in that** the first signal strength (S1) is five times to fifty times greater than the second signal strength (S2), preferably ten times to twenty times.

7. Method according to any of the preceding claims, **characterized in that** the first signal strength (S1) is 10 digits to 200 digits, preferably 60 digits to 100 digits, on a controller of the operator control device (18).

8. Method according to any of the preceding claims, **characterized in that** the second signal strength (S2) is 3 digits to 10 digits, preferably 5 digits to 7 digits, on a controller of the operator control device (18).

9. Method according to any of the preceding claims, **characterized in that** an inquiry of the sensor elements (20) is made more than once per second by the operator control device (18) whether a finger (F) has approached or has been placed onto the operator control panel (12) above a sensor element (20), preferably an inquiry is made at least 10 times per second, wherein for optical marking of the ON sensor element (20a) it is sufficient that during a single one of said inquiries a signal having a signal strength (S) greater than the second signal strength (S2) is detected.

10. Method according to any of the preceding claims, **characterized in that** the operator control device (18) is configured such that with a distance of a finger (F) of at maximum 5 cm, in particular of at maximum 3 cm, above the operator control panel (12) above a sensor element (20) a signal having the second signal strength (S2) is generated at the sensor element (20) and detected by the operator control device (18).

11. Method according to any of the preceding claims, **characterized in that** an acoustic signaling is given not earlier than a sensor element (20) with a signal strength (S) exceeding the first signal strength (S1) has been activated.

12. Method according to any of the preceding claims, **characterized in that** an optical marking of a sensor element (20) by illumination from below is made, preferably using LED (21), in particular passing through the sensor elements (20).

13. Electrical cooking device, in particular electrical cooktop (11), which has an operator control device (18) with an operator control panel (12) and with sensor elements (20) disposed below the control panel (12), wherein:
- the sensor elements (20) are switches of the operator control device (18),
- the operator control device (18) is configured such that by approaching or placing a finger (F) onto the operator control panel (12) above a sensor element (20) an operating function of the related switch is triggerable and said operating function is triggered if, by said approaching or placing-on of the finger (F) to the sensor element (20), a signal which has a signal strength (S) greater than a first signal strength (S1), is generated on the sensor element (20) and detected by the operator control device, wherein a signal strength is increasing with a decreasing distance of the finger to the operator control panel, wherein
- a switch with an ON sensor element (20a) is an ON switch for the electrical cooking device (11),
- the operator control device (18) has a control system which is configured to perform the method according to any of the preceding claims therewith.

## Revendications

1. Procédé de commande d'un appareil de cuisson électrique (11), en particulier d'une table de cuisson électrique, dans lequel :
- l'appareil de cuisson électrique (11) présente un dispositif de commande (18) avec un panneau de commande (12) et avec éléments de capteur (20) disposés en dessous du panneau de commande,
- les éléments de capteur (20) forment commutateurs du dispositif de commande (18),
- un commutateur avec un élément de capteur MARCHE (20a) est présent sous forme de commutateur MARCHE pour l'appareil de cuisson électrique (11),
- par approcher ou poser un doigt (F) sur le panneau de commande (12) au-dessus d'un élément de capteur (20) une fonction d'opération du commutateur associé est déclenchable et ladite fonction d'opération soit déclenchée si, par ce rapprochement ou positionnement du doigt (F) sur l'élément de capteur (20), un signal présentant une intensité de signal (S) supérieure à une première intensité de signal (S1) est généré sur l'élément de capteur et détecté par le dispositif de commande (18), dans lequel une intensité de signal augmente lorsque la distance du doigt au panneau de commande dé-croit, dans lequel
- dans une première étape dans un état ARRET de l'appareil de cuisson électrique (11) au moins l'un des éléments de capteur (20), en cas de génération sur l'élément de capteur (20) et détection par le dispositif de commande (18) d'un signal par rapprochement ou positionnement d'un doigt (F) sur le panneau de commande (12) au-dessus de cet élément de capteur (20) avec au moins une deuxième intensité de signal (S2) de ce signal inférieure à la première intensité de signal (S1), provoque le dispositif de commande (18) à marquer optiquement par éclairage au moins l'élément de capteur MARCHE (20a) du commutateur MARCHE,
- dans une deuxième étape suivante par positionnement du doigt (F) sur le panneau de commande (12) au-dessus de cet élément de capteur MARCHE (20a) marqué optiquement du commutateur MARCHE avec génération et détection d'un signal présentant une intensité de signal (S) supérieure à la première intensité de signal (S1) l'appareil de cuisson électrique (11) est mise en marche de telle manière que le dispositif de commande (18) marque optiquement plusieurs, en particulier tous, des éléments de capteur (20) de commutateurs par éclairage pour une opération suivante possible des commutateurs formés par les éléments de capteur (20) par rapprochement ou positionnement d'un doigt (F) au-dessus sur le panneau de commande (12),
**caractérisé en ce**
**qu'**en cas de génération et détection d'un signal présentant la deuxième intensité de signal (S2) sur l'un quelconque des éléments de capteur (20) exclusivement l'élément de capteur MARCHE (20a) du commutateur MARCHE soit marqué optiquement par éclairage.

2. Procédé selon la revendication 1, **caractérisé en ce que** le panneau de commande (12) sur le plan de l'élément de capteur MARCHE (20a) est formé sans marquage optiquement détectable ou non-marqué, dans lequel de préférence sur le plan du dispositif de commande (18) ou au-dessus de chacun des éléments de capteur (20) aucun marquage optique est présent sur le panneau de commande (12), en particulier pas d'impression ou similaire sur le côté supérieur (13a) du panneau de commande entier ou d'une partie formant le panneau de commande.

3. Procédé selon la revendication 1 ou 2, **caractérisé en ce que** le commutateur MARCHE est agencé seulement pour enclencher et pour déclencher l'appareil de cuisson électrique (11), de préférence sans aucune autre fonction.

4. Procédé selon l'une des revendications précédentes, **caractérisé en ce que** plusieurs, de préférence tous, éléments de capteur (20) sont commandés dans une première étape de manière à détecter le rapprochement ou positionnement d'un doigt (F) sur le panneau de commande (12) présentant une intensité de signal (S) d'au moins la deuxième intensité de signal (S2).

5. Procédé selon l'une des revendications précédentes, **caractérisé en ce que** le marquage optique de l'élément de capteur MARCHE (20a) pour une mise en marche du dispositif de commande (18) pendant la deuxième étape à lieu de façon limitée dans le temps, en particulier limitée à un temps de 3 secondes à 10 secondes, dans lequel aussitôt après le marquage optique est annulé encore.

6. Procédé selon l'une des revendications précédentes, **caractérisé en ce que** la première intensité de signal (S1) est cinq fois à cinquante fois supérieure à la deuxième intensité de signal (S2), de préférence dix fois à vingt fois supérieure.

7. Procédé selon l'une des revendications précédentes, **caractérisé en ce que** la première intensité de signal (S1) est 10 digits à 200 digits, de préférence 60 digits à 100 digits, sur un contrôleur du dispositif de commande (18).

8. Procédé selon l'une des revendications précédentes, **caractérisé en ce que** la deuxième intensité de signal (S2) est 3 digits à 10 digits, de préférence 5 digits à 7 digits, sur un contrôleur du dispositif de commande (18).

9. Procédé selon l'une des revendications précédentes, **caractérisé en ce qu'**une interrogation des éléments de capteur (20) est effectuée par le dispositif de commande (18) plus qu'une fois par seconde si un doigt (F) s'est approché ou était posé sur le panneau de commande (12) au-dessus d'un élément de capteur (20), de préférence une interrogation se fait au moins 10 fois par seconde, dans lequel il suffit pour un marquage optique des éléments de capteur MARCHE (20a) que pendant une seule desdites interrogations un signal présentant une intensité de signal (S) supérieure à la deuxième intensité de signal (S2) est détecté.

10. Procédé selon l'une des revendications précédentes, **caractérisé en ce que** le dispositif de commande (18) est configuré de telle manière que lors d'une distance d'un doigt (F) d'au maximum 5 cm, en particulier d'au maximum 3 cm, au-dessus du panneau de commande (12) au-dessus d'un élément de capteur (20) un signal présentant la deuxième intensité de signal (S2) est généré sur l'élément de capteur (20) et détecté par le dispositif de commande (18).

11. Procédé selon l'une des revendications précédentes, **caractérisé en ce qu'**une signalisation acoustique ne se fait pas avant qu'une activation d'un élément de capteur (20) présentant une intensité de signal (S) supérieure à la première intensité de signal (S1) a eu lieu.

12. Procédé selon l'une des revendications précédentes, **caractérisé en ce qu'**un marquage optique d'un élément de capteur (20) est fait par éclairage du bas, de préférence au moyen de LED (21), en particulier à travers les éléments de capteur (20).

13. Appareil de cuisson électrique, en particulier table de cuisson électrique (11), présentant un dispositif de commande (18) avec un panneau de commande (12) et avec éléments de capteur (20) disposés en dessous du panneau de commande (12), dans lequel :
- les éléments de capteur (20) forment commutateurs du dispositif de commande (18),
- le dispositif de commande (18) est configuré de telle manière que par rapprochement ou positionnement d'un doigt (F) sur le panneau de commande (12) au-dessus d'un élément de capteur (20) une fonction d'opération du commutateur associé est déclenchable et ladite fonction d'opération soit déclenchée si, par ce rapprochement ou positionnement du doigt (F) sur l'élément de capteur (20), un signal présentant une intensité de signal (S) supérieure à une première intensité de signal (S1) est généré sur l'élément de capteur (20) et détecté par le dispositif de commande, dans lequel une intensité de signal augmente lorsque la distance du doigt au panneau de commande décroit, dans lequel
- un commutateur avec un élément de capteur MARCHE (20a) est présent sous forme de commutateur MARCHE pour l'appareil de cuisson électrique (11),
- le dispositif de commande (18) présente un système de commande configuré pour exécuter le procédé selon l'une des revendications précédentes avec ledit système.
